# EUROPÄISCHE PATENTSCHRIFT

(11) **EP 1 299 909 B1**
(45) Veröffentlichungstag und Bekanntmachung des Hinweises auf die Patenterteilung: **24.01.2018**
(21) Anmeldenummer: 01949261.0
(22) Anmeldetag: 13.06.2001
(51) Int. Cl.: H01L 33/00, H01L 33/12, H01L 33/32

(54) **LUMINESZENZDIODENCHIP AUF DER BASIS VON InGaN UND VERFAHREN ZU DESSEN HERSTELLUNG**
INGAN-BASED LIGHT-EMITTING DIODE CHIP AND A METHOD FOR THE PRODUCTION THEREOF
PUCE A DIODE ELECTROLUMINESCENTE A BASE D'INGAN ET SON PROCEDE DE FABRICATION

(30) Priorität: 03.07.2000 DE 10032246
(43) Veröffentlichungstag der Anmeldung: 09.04.2003
(73) Patentinhaber: OSRAM Opto Semiconductors GmbH, 93055 Regensburg (DE)
(72) Erfinder: BAUR, Johannes, 93180 Deuerling (DE); BRÜDERL, Georg, 93133 Burglengenfeld (DE); HAHN, Berthold, 93155 Hohenschambach (DE); HÄRLE, Volker, 93164 Laaber (DE); STRAUSS, Uwe, 93077 Bad Abbach (DE)
(74) Vertreter: Epping - Hermann - Fischer
(86) Internationale Anmeldenummer: PCT/DE2001/002190
(87) Internationale Veröffentlichungsnummer: WO 2002/003479

(56) Entgegenhaltungen:
- JP-A- 10 294 532
- JP-A- 2000 040 858
- HAERLE V ET AL: "GaN-based LEDs and lasers on SiC" PHYSICA STATUS SOLIDI A, Bd. 180, Nr. 1, 5. März 2000 (2000-03-05), Seiten 5-13, XP000994618 ISSN: 0031-8965

## Beschreibung

Die Erfindung bezieht sich auf einen Lumineszenzdiodenchip auf der Basis von InGaN und auf ein Verfahren zum Herstellen eines Lumineszenzdiodenchips auf der Basis von InGaN.
Unter Lumineszenzdiodenchips auf der Basis von InGaN sind im Zusammenhang mit der vorliegenden Erfindung grundsätzlich alle Lumineszenzdiodenchips zu fassen, deren strahlungsemittierende Zone InGaN oder verwandte Nitride sowie darauf basierende Mischkristalle, wie beispielsweise Ga(Al,In)N, aufweist.
Lumineszenzdiodenchips auf der Basis von InGaN sind beispielsweise aus Shuji Nakamura, Gerhard Fasol, The Blue Laser Diode, Springer Verlag Berlin Heidelberg 1997, S. 209ff bekannt.
Aus der Druckschrift JP 10-294532 A sind Nitrid-basierte LEDs und Herstellungsverfahren hierfür bekannt, ebenso wie aus der Druckschrift JP 2000-040858 A. Die Aufgabe der Erfindung besteht darin, einen Lumineszenzdiodenchip der eingangs genannten Art mit einer möglichst hohen Strahlungsstärke zur Verfügung zu stellen. Weiterhin soll ein Verfahren zum Herstellen eines solchen Lumineszenzdiodenchips angegeben werden.
Die erstgenannte Aufgabe wird mit einem Lumineszendiodenchip mit den Merkmalen des Patentanspruches 1 gelöst. Vorteilhafte Weiterbildungen sind Gegenstand der Patentansprüche 2 bis 3. Die weitere genannte Aufgabe wird durch ein Verfahren gemäß dem Patentanspruch 4 gelöst. Bevorzugte Weiterbildungen dieses Verfahrens sind Gegenstand der Patentansprüche 5 und 6.

Bei einem Lumineszenzdiodenchip gemäß der Erfindung ist über einem Substrat eine Epitaxieschichtenfolge mit einer strahlungsemittierenden aktiven Struktur auf der Basis von InGaN aufgewachsen. Zwischen dem Substrat und der strahlungsemittierenden aktiven Struktur ist eine Pufferschicht, bestehend aus einer oder mehreren Schichten angeordnet. Das Material bzw. die Materialien der Pufferschicht sind derart gewählt, daß deren Aufwachsoberfläche für das Aufwachsen der strahlungsemittierenden aktiven Struktur bei deren Wachstumstemperatur/en unverspannt ist. Die strahlungsemittierende aktive Struktur weist in Bezug auf die Aufwachsebene lateral nebeneinander angeordnete In-reichere Zonen auf, in denen der In-Gehalt höher ist als in übrigen Bereiche der aktiven Struktur.

Bei einer bevorzugten Weiterbildung des Lumineszenzdiodenchips besteht das Substrat im wesentlichen aus elektrisch leitendem SiC. Dadurch läßt sich der Chip vorteilhafterweise in einer üblichen Leuchtdiodenchipstruktur realisieren, bei dem die Kontaktflächen auf einander gegenüberliegenden Seiten des Chips angeordnet sind. Folglich ist auf einfache Weise eine Stromeinprägung über einen großen Bereich des lateralen Chip-Querschnitts möglich. Im Gegensatz dazu muß bei Chips mit elektrisch isolierendem Substrat die dem Substrat zugewandte Seite der Epitaxieschichtenfolge von deren Oberseite her kontaktiert werden. Dies ist mit einem deutlich höheren Herstellaufwand verbunden, weil die Epitaxieschichtenfolge nach deren Herstellung mit Ätzgräben versehen oder strukturiert aufgewachsen werden muß, um die n-Seite der aktiven Struktur kontaktieren zu können.

Bei einer besonders bevorzugten Weiterbildung des Lumineszenzdiodenchips weist die aktive Struktur eine Multi-Quantenwell-Struktur auf, bei der mindestens ein Quantenwell die In-reichen Zonen enthält. Gemäß der Erfindung enthält die Pufferschichtenfolge eine wenige hundert Nanometer dicke AlGaN:Si, der in Aufwachsrichtung eine GaN:Si-Schicht nachgeordnet ist. Letztere weist eine Dicke zwischen 1 µm und 3 µm auf. Die Oberfläche der GaN:Si-Schicht bildet die Aufwachsoberfläche für das Aufwachsen der strahlungsemittierenden aktiven Struktur Epitaxieschichtenfolge und ist bei der oder den Aufwachstemperatur/en der InGaN-basierenden Schicht unverspannt.

Bei dem erfindungsgemäßen Verfahren wird über einem Substrat eine strahlungsemittierende Epitaxieschichtenfolge mit einer strahlungsemittierenden aktiven Struktur auf der Basis von InGaN abgeschieden. Vor dem Aufwachsen der strahlungsemittierenden aktiven Struktur wird eine Pufferschicht oder - schichtenfolge auf das Substrat aufgewachsen, deren Aufwachsoberfläche für das Aufwachsen der strahlungsemittierenden aktiven Struktur bei deren Wachstumstemperatur/en unverspannt ist.

Mit diesem Verfahren wird erreicht, daß die aktive Struktur in Bezug auf die Aufwachsebene lateral nebeneinander angeordnete In-reichere Zonen aufweist, in denen der In-Gehalt höher ist als in übrigen Bereiche der aktiven Struktur.

Bei einer besonders bevorzugten Ausführungsform des Verfahrens wird als aktive Struktur eine Single-Quantenwell- oder eine Multi-Quantenwell-Struktur mit InGaN-Quantenwells erzeugt und ein auf SiC basierendes Substrat verwendet.

Als Pufferschicht wird über dem Substrat zunächst eine wenige hundert Nanometer dicke AlGaN:Si-Schicht epitaktisch abgeschieden, über der eine GaN:Si-Schicht epitaktisch aufgewachsen wird. Die Dicke der GaN:Schicht liegt zwischen 1 µm und 3 µm und auf deren Oberfläche wird die strahlungsemittierende aktive Struktur abgeschieden.

Als Epitaxieverfahren eignet sich vorzugsweise die metallorganische Dampfphasen-Epitaxie (MOVPE für Metal Organic Vapour Phase Epitaxy).

Weitere vorteilhafte Ausgestaltungen und Weiterbildungen der Erfindung ergeben sich aus den im Folgenden in Verbindung mit den Figuren 1a bis 2 beschriebenen Ausführungsbeispielen. Es zeigen:
Figur 1a, eine schematische Darstellung eines Schnittes durch ein erstes Ausführungsbeispiel;
Figur 1b, eine schematische Darstellung eines vorteilhaften Kontaktdesigns und einer vorteilhaften Montageart des ersten Ausführungsbeispieles;
Figur 2, eine schematische Darstellung eines Schnittes durch ein zweites Ausführungsbeispiel einschließlich deren vorteilhafter Montageart.

In den Figuren der verschiedenen Ausführungsbeispiele sind gleiche oder gleichwirkende Bestandteile jeweils mit denselben Bezugszeichen versehen.

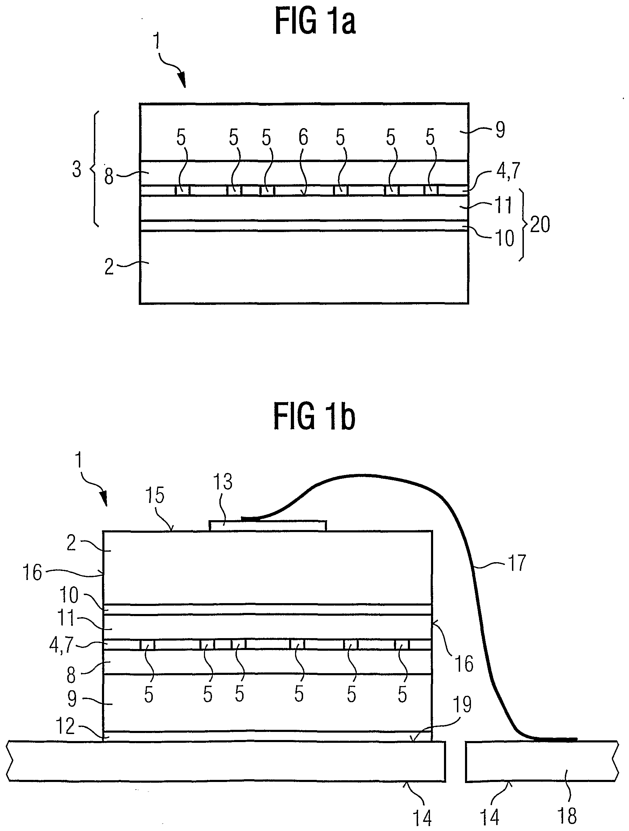

Bei dem Lumineszenzdiodenchip 1 von Figur 1a ist über einem SiC-Substrat 2 eine strahlungsemittierende aktive Struktur 4 angeordnet. Diese weist im vorliegenden Beispiel eine InGaN-Single-Quantenwell 7 auf.

Die strahlungsemittierende aktive Struktur 4 enthält eine Mehrzahl von in Bezug auf die Aufwachsebene lateral nebeneinander angeordneten In-reichen Zonen 5, in denen der In-Gehalt höher ist als in den übrigen Bereichen der aktiven Struktur 4. Der In-Gehalt in den In-reichen Zonen 5 beträgt beispielsweise bis zu 40%.

Über der strahlungsemittierenden aktiven Struktur 4 ist eine dünne p-leitend dotierte AlGaN-Epitaxieschicht 8 und eine beispielsweise 200nm dicke p-leitend dotierte GaN-Schicht 9 aufgewachsen.

Ebenso kann beispielsweise eine auf InGaN basierende strahlungsemittierende aktive Struktur 4 mit einer Doppelheterostruktur oder einer Multi-Quantenwell(MQW)-Struktur mit mehreren Quantenwells vorgesehen sein.

Das SiC-Substrat 2 ist elektrisch leitfähig und für die von der Epitaxieschichtenfolge 3 ausgesandte Strahlung zumindest teilweise durchlässig.

Zwischen dem Substrat 2 und der aktiven Struktur 4 befindet sich eine Pufferschicht 20, die eine wenige hundert Nanometer dicke AlGaN:Si-Schicht 10, der in Aufwachsrichtung eine GaN:Si-Schicht 11 nachgeordnet ist, enthält. Die GaN:Si-Schicht 11 weist eine Dicke zwischen 1 µm und 3 µm auf und deren von dem Substrat 2 abgewandte Oberfläche bildet bei der Herstellung des Chips 1 die Aufwachsoberfläche 6 für das Aufwachsen der auf InGaN basierenden strahlungsemittierenden aktiven Struktur 4.

Bei dem Kontaktdesign und der Montageart des Chips gemäß Figur 1b, der hinsichtlich seiner Epitaxieschichtstruktur 3 dem Chip 1 von Figur 1a entspricht, ist auf der p-leitend dotierten GaN-Schicht 9 eine bondfähige p-Kontaktschicht 12 aufgebracht. Diese besteht beispielsweise aus Ag, aus einer PtAg- und/oder einer PdAg-Legierung oder ist beispielsweise aus einer strahlungsdurchlässigen ersten Schicht und einer spiegelnden zweiten Schicht zusammengesetzt. Bei der zweitgenannten Alternative besteht die erste Schicht beispielsweise im Wesentlichen aus Pt und/oder Pd und die zweite Schicht beispielsweise im Wesentlichen aus Ag, Au und/oder Al oder einer dielektrischen Spiegelschicht.

Auf seiner von der Epitaxieschichtenfolge 3 abgewandten Seite 15 ist das SiC-Substrat 2 mit einer Kontaktmetallisierung 13 versehen, die nur einen Teil dieser Hauptfläche 15 bedeckt und als Bondpad zum Drahtbonden ausgebildet ist.

Der Chip 1 ist mittels Die-Bonden mit seiner p-Seite, das heißt mit der p-Kontaktschicht 12 auf eine Chipmontagefläche 19 eines elektrischen Anschlußrahmens 14 (Leadframe) montiert. Die n-Kontaktmetallisierung 13 ist über einen Bonddraht 17 mit einem Anschlußteil 18 des Anschlußrahmens 14 verbunden.

Die Lichtauskopplung aus dem Chip 1 erfolgt über den freien Bereich der Hauptfläche 15 des SiC-Substrats 2 und über die Chipflanken 16.

Optional weist der Chip 1 ein nach dem Aufwachsen der Epitaxieschichtenfolge 3 gedünntes SiC-Substrat 2 auf. Ebenso kann das Substrat 2 nach dem Aufwachsen der Epitaxieschichtenfolge 3 vollständig von dieser entfernt werden, wodurch eine sogenannte Dünnschicht-LED erzeugt wird.

Selbstverständlich kann der erfindungsgemäße Chip 1 auch mit seiner Substratseite, d.h. in sogenannter "up side up"-Montage auf der Chipmontagefläche 13 eines elektrischen Anschlußrahmens 14 (Leadframe) montiert sein. Das Kontaktdesign ist dann natürlich an diese Montageart anzupassen. Mögliche Materialien für geeignete Kontaktmetallisierung sind aus dem Stand der Technik bekannt und werden von daher an dieser Stelle nicht näher erläutert.

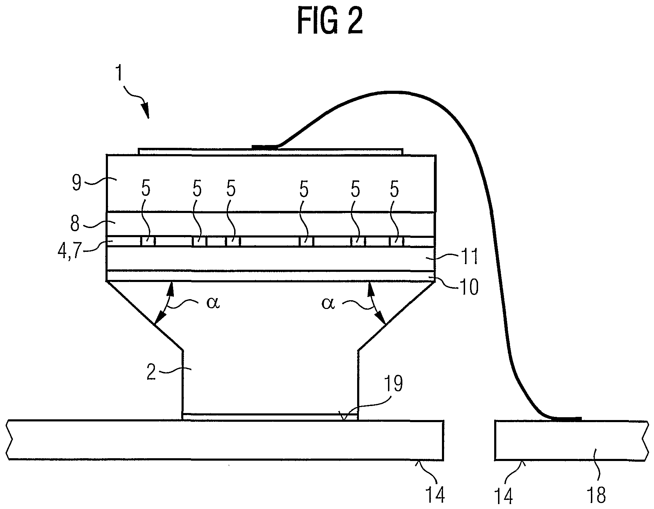

Das in Figur 2 dargestellte Ausführungsbeispiel unterscheidet sich von dem der Figuren 1a und 1b im Wesentlichen dadurch, daß die Chipflanken 16 im Bereich unterhalb der aktiven Struktur 4 schräg zur Haupterstreckungsrichtung der Quantenwell 7 stehen, die dann im weiteren Verlauf zur Unterseite hin wieder in senkrecht zur Haupterstreckungsrichtung der Quantenwell 7 stehende Seitenflächen übergehen, so daß einerseits eine verbesserte Auskopplung der in der aktiven Zone erzeugten Strahlung durch die Seitenflächen erzielt wird und andererseits eine sichere Flip-Chip-Montage mit herkömmlichen Chip-Montageanlagen möglich ist. Der Winkel α der schräg stehenden Bereiche der Seitenflächen zur Quantenwell beträgt vorzugsweise zwischen 20° und 80°, besonders vorteilhaft ist ein Winkel von ca. 30°.

Diese Chipstruktur gemäß Figur 2 wird mittels eines Formsägeblattes erzeugt, dessen Stirnfläche V-förmig ist und mit dem der Epitaxiewafer vor dem Separieren zu einzelnen Chips 1 mit der in Figur 2 dargestellten Form eingesägt wird.

Bei einem Verfahren zum Herstellen eines Lumineszenzdiodenbauelements gemäß den Ausführungsbeispielen wird zunächst auf dem Substrat 2 mittels metallorganischer Gasphasenepitaxie (MOVPE) die wenige hundert Nanometer dicke AlGaN:Si-Schicht 10 und die GaN:Si-Schicht 11 aufgebracht. Nachfolgend wird die strahlungsemittierende aktive Struktur 4 abgeschieden, wobei die dafür vorgesehene Aufwachsoberfläche, die im vorliegenden Fall von der freien Hauptfläche der GaN:Si-Schicht 11 gebildet wird, bei der oder den Wachstumstemperatur/en der InGaN-basierenden aktiven Struktur unverspannt ist.

In Folgenden ist ein Vergleichsversuch von zwei bis auf die Aufwachsoberfläche der GaN:Si-Schicht 11 nach dem oben beschriebenen Verfahren identisch hergestellten Chips 1 erläutert.

Probe 1 ist hierbei ein Chip, bei dem die Aufwachsoberfläche 6 bei der Wachstumstemperatur der InGaN-basierenden Schicht stark kompressiv verspannt ist.

Die Aufwachsoberfläche 6 bei Probe 2 weist dagegen bei der Wachstumstemperatur der InGaN-basierenden Schicht keine oder nur eine geringfügige Verspannung auf.

Eine Analyse der Chips zeigt, daß die Probe 1 sehr glatte Grenzflächen zwischen den verschiedenen Epitaxieschichten der aktiven Schichtenfolge und einen homogenen In-Gehalt von etwa 15% aufweist, wohingegen bei der Probe 2 die Grenzflächen zwischen den verschiedenen Epitaxieschichten der aktiven Schichtenfolge sehr rauh sind und die Struktur dot-artig lokal erhöhte Gitterkonstanten aufweist, die mit lokal erhöhten In-Gehalten von bis zu 40% korrespondieren.

Die Probe 2 zeigt bei Montage in eine 5mm-Radial-Bauform bei 20mA Vorwärtsstrom eine gegenüber Probe 1 deutlich erhöhte Leistung, bei gleichzeitiger Verschiebung der Peak-Wellenlänge zu größeren Wellenlängen hin.

## Patentansprüche

1. Lumineszenzdiodenchip (1), bei dem
über einem Substrat (2) eine Epitaxieschichtenfolge (3) mit einer strahlungsemittierenden aktiven Struktur (4) auf der Basis von InGaN und zwischen dem Substrat (2) und der aktiven Struktur (4) eine Pufferschichtenfolge (20) angeordnet sind, die aktive Struktur (4) in Bezug auf die Aufwachsebene lateral nebeneinander angeordnete In-reiche Zonen (5) aufweist, in denen der In-Gehalt höher ist als in übrigen Bereiche der aktiven Struktur (4),
**dadurch gekennzeichnet, dass**
die Pufferschichtenfolge (20) eine wenige hundert Nanometer dicke AlGaN:Si-Schicht (10) aufweist, der in Aufwachsrichtung eine GaN:Si-Schicht (11) nachgeordnet ist, die eine Dicke zwischen 1 µm und 3 µm aufweist und auf deren Oberfläche (6) die strahlungsemittierende aktive Struktur (4) abgeschieden ist.

2. Lumineszenzdiodenchip (1) nach Anspruch 1, **dadurch gekennzeichnet, dass** das Substrat (2) aus SiC besteht.

3. Lumineszenzdiodenchip (1) nach Anspruch 1 oder 2, **dadurch gekennzeichnet, dass** die aktive Struktur (4) eine Single-Quantenwell-Struktur oder eine Multi-Quantenwell-Struktur aufweist, bei der der bzw. mindestens ein Quantenwell die In-reichen Zonen (5) enthält.

4. Verfahren zum Herstellen eines Lumineszenzdiodenchips auf der Basis von InGaN, bei dem
über einem Substrat (2) eine Epitaxieschichtenfolge (3) mit einer strahlungsemittierenden aktiven Struktur (4) auf der Basis von InGaN abgeschieden wird, wobei vor dem Aufwachsen der strahlungsemittierenden aktiven Struktur (4) eine Pufferschichtenfolge (20) auf das Substrat (2) aufgewachsen wird, deren Aufwachsoberfläche (6) für das Aufwachsen der strahlungsemittierenden aktiven Struktur (4) bei deren Wachstumstemperatur/en unverspannt ist, die aktive Struktur (4) in Bezug auf die Aufwachsebene lateral nebeneinander angeordnete In-reiche Zonen (5) aufweist, in denen der In-Gehalt höher ist als in übrigen Bereichen der aktiven
Struktur,
**dadurch gekennzeichnet, dass**
zum Aufbringen der Pufferschichtenfolge (20) über dem Substrat (2) zunächst eine wenige hundert Nanometer dicke AlGaN:Si-Schicht (10) abgeschieden wird, über der eine GaN:Si-Schicht (11) aufgewachsen wird, die eine Dicke zwischen 1 µm und 3 µm aufweist und auf deren Oberfläche (6) die strahlungsemittierende aktive Struktur (4) abgeschieden wird.

5. Verfahren nach Anspruch 4,
**dadurch gekennzeichnet, dass** als aktive Struktur (4) eine Multi-Quantenwell-Struktur mit InGaN-Quantenwells erzeugt wird.

6. Verfahren nach Anspruch 4 oder 5,
**dadurch gekennzeichnet, dass** als Substrat (2) ein SiC-Substrat verwendet wird.

## Claims

1. Luminance diode chip (1), wherein
above a substrate (2) there are arranged an epitaxial layer sequence (3) comprising a radiation-emitting active structure (4) on the basis of InGaN and between the substrate (2) and the active structure (4) a buffer layer sequence (20), the active structure (4) has In-rich zones (5) arranged alongside one another laterally with respect to the growth plane, in which zones the In content is higher than in remaining regions of the active structure (4),
**characterized in that**
the buffer layer sequence (20) comprises an AlGaN:Si layer (10) having a thickness of a few hundred nanometres, downstream of which in the growth direction there is disposed a GaN:Si layer (11) which has a thickness of between 1 µm 3 µm and on the surface (6) of which the radiation-emitting active structure (4) is deposited.

2. Luminance diode chip (1) according to Claim 1, **characterized in that** the substrate (2) consists of SiC.

3. Luminance diode chip (1) according to Claim 1 or 2, **characterized in that** the active structure (4) comprises a single quantum well structure or a multi quantum well structure, wherein the or at least one quantum well contains the In-rich zones (5).

4. Method for producing a luminance diode chip on the basis of InGaN, wherein
an epitaxial layer sequence (3) comprising a radiation-emitting active structure (4) on the basis of InGaN is deposited above a substrate (2), wherein, before the growth of the radiation-emitting active structure (4), a buffer layer sequence (20) is grown onto the substrate (2), the growth surface (6) of said buffer layer sequence for the growth of the radiation-emitting active structure (4) being unstressed at the growth temperature(s) thereof, the active structure (4) has In-rich zones (5) arranged alongside one another laterally with respect to the growth plane, in which zones the In content is higher than in remaining regions of the active structure,
**characterized in that**
for applying the buffer layer sequence (20) above the substrate (2) firstly an AlGaN:Si layer (10) having a thickness of a few hundred nanometres is deposited, above which is grown a GaN:Si layer (11) which has a thickness of between 1 µm and 3 µm and on the surface (6) of which the radiation-emitting active structure (4) is deposited.

5. Method according to Claim 4,
**characterized in that** a multi quantum well structure comprising InGaN quantum wells is produced as the active structure (4).

6. Method according to Claim 4 or 5,
**characterized in that** an SiC substrate is used as the substrate (2).

## Revendications

1. Puce de diode électroluminescente (1), avec laquelle une séquence de couches épitaxiales (3) comportant une structure active (4) émettrice de rayonnement à base d'InGaN est disposée sur un substrat (2) et, entre le substrat (2) et la structure active (4), une séquence de couches tampon (20), la structure active (4) possédant des zones riches en In (5) disposées latéralement les unes à côté des autres en référence au plan de croissance, dans lesquelles la teneur en In est supérieure à celle dans les autres zones de la structure active (4),
**caractérisée en ce que** la séquence de couches tampon (20) possède une couche d'AlGaN:Si (10) de quelques centaines de nanomètres d'épaisseur à la suite de laquelle est disposée, dans le sens de la croissance, une couche de GaN:Si (11) qui possède une épaisseur comprise entre 1 µm et 3 µm et sur la surface (6) de laquelle est déposée la structure active (4) émettrice de rayonnement.

2. Puce de diode électroluminescente (1) selon la revendication 1, **caractérisée en ce que** le substrat (2) est constitué de SiC.

3. Puce de diode électroluminescente (1) selon la revendication 1 ou 2, **caractérisée en ce que** la structure active (4) possède une structure à puits quantique unique ou une structure à puits quantiques multiples, dans laquelle le ou au moins un puits quantique contient les zones riches en In (5) .

4. Procédé de fabrication d'une puce de diode électroluminescente à base d'InGaN, selon lequel une séquence de couches épitaxiales (3) comportant une structure active (4) émettrice de rayonnement à base d'InGaN est déposée sur un substrat (2), une séquence de couches tampon (20) étant mise en croissance sur le substrat (2) avant la croissance de la structure active (4) émettrice de rayonnement, dont la surface de croissance (6) pour la croissance de la structure active (4) émettrice de rayonnement n'est soumise à aucune contrainte à sa/ses température(s) de croissance, la structure active (4) possédant des zones riches en In (5) disposées latéralement les unes à côté des autres en référence au plan de croissance, dans lesquelles la teneur en In est supérieure à celle dans les autres zones de la structure active, **caractérisé en ce que** en vue de l'application de la séquence de couches tampon (20), une couche d'AlGaN:Si (10) de quelques centaines de nanomètres d'épaisseur est tout d'abord déposée sur le substrat (2), couche sur laquelle est mise en croissance une couche de GaN:Si (11) qui possède une épaisseur comprise entre 1 µm et 3 µm et sur la surface (6) de laquelle est déposée la structure active (4) émettrice de rayonnement.

5. Procédé selon la revendication 4, **caractérisé en ce que** la structure active (4) produite est une structure à puits quantiques multiples comprenant des puits quantiques en InGaN.

6. Procédé selon la revendication 4 ou 5, **caractérisé en ce que** le substrat (2) utilisé est un substrat en SiC.
